# EUROPÄISCHE PATENTSCHRIFT

(11) **EP 3 085 474 B1**
(45) Veröffentlichungstag und Bekanntmachung des Hinweises auf die Patenterteilung: **06.03.2019**
(21) Anmeldenummer: 16164876.1
(22) Anmeldetag: 12.04.2016
(51) Int. Cl.: B22D 19/00, B22D 19/04, H01L 23/552

(54) **KONSTRUKTIONSBAUTEIL EINES TECHNISCHEN GEGENSTANDS SOWIE VERFAHREN ZUR HERSTELLUNG DES KONSTRUKTIONSBAUTEILS**
CONSTRUCTION COMPONENT OF A TECHNICAL OBJECT AND METHOD FOR PRODUCTION OF SAID CONSTRUCTION COMPONENT
COMPOSANT DE CONSTRUCTION D'UN OBJET TECHNIQUE ET PROCEDE DE LEURS PRODUCTION DUDIT COMPOSANT DE CONSTRUCTION

(30) Priorität: 20.04.2015 DE 102015106002
(43) Veröffentlichungstag der Anmeldung: 26.10.2016
(73) Patentinhaber: Gottfried Wilhelm Leibniz Universität Hannover, 30167 Hannover (DE)
(72) Erfinder: FREYTAG, Patrik, 30826 Garbsen (DE); MAIER, Prof. Dr. Hans Jürgen, 30419 Hannover (DE); RISSING, Lutz, 80337 München (DE); KLAAS, Daniel, 30167 Hannover (DE); WIENECKE, Anja, 38486 Klötze (DE)
(74) Vertreter: Günther, Constantin

(56) Entgegenhaltungen:
- DE-A1- 10 315 425
- DE-A1-102007 003 541
- DE-A1-102009 036 549
- DE-A1-102010 046 170
- DE-U1-202005 021 246
- JP-A- 2005 109 306

## Beschreibung

Die Erfindung betrifft ein Konstruktionsbauteil eines technischen Gegenstands gemäß dem Anspruch 1. Die Erfindung betrifft außerdem ein Verfahren zur Herstellung eines Konstruktionsbauteils der zuvor genannten Art.

Allgemein betrifft die Erfindung das Gebiet der Integration von elektrischen Bauteilen in metallischen Gussmaterialien. Solche elektrischen Bauteile können elektrische Bauteile aller Art sein, von einer einfachen elektrischen Leitung (Kabel) bis hin zu elektrischen Funktionsbauteilen, wie z.B. Sensoren und/oder Aktoren. Ein Bedarf besteht z.B. darin, Sensoren in Gussbauteile zu integrieren, um neue Möglichkeiten der Bauteilüberwachung und/oder der Sensierung bestimmter physikalischer Größen zu erschließen.

Während das Integrieren von Sensoren in Kunststoffmaterialien ohne weiteres möglich ist, treten bei dem Versuch, Sensoren in metallische Gussmaterialien zu integrieren, besondere Probleme auf, die mit den besonderen Materialeigenschaften metallischer Gussmaterialien zu tun haben. Zudem stellen die bei Gießprozessen mit metallischen Gussmaterial auftretenden hohen Temperaturen besondere Schwierigkeiten dar, da das Eingießen des elektrischen Bauteils in dem metallischen Gussmaterial sinnlos ist, wenn das elektrische Bauteil dabei derart beschädigt wird, dass es seine elektrische Funktion nicht mehr ausführen kann.

Aus der DE 20 2005 021 246 U1 ist ein mittels eines Druckgussverfahrens herstellbares Bauteil aus Metall bekannt, das ein oder mehrere eingegossene Funktionselemente enthält. Aus der DE 10 2009 036 549 A1 gehen Verfahren und Vorrichtungen zur Herstellung eines Bauteils mit einem integrierten Einlegeteil hervor. Aus der DE 10 2007 003 541 A1 geht ein elektronisches Bauteil hervor.

Aus der JP 2005/109306 A geht eine mit Epoxidharz vergossene elektronische Baugruppe hervor. Aus der DE 10 2010 046 170 A1 geht ein Gussteil mit eingegossenem Transponder hervor. Aus der DE 103 15 425 A1 geht ein Verfahren zur Herstellung eines Bauelements mit einer piezoelektrischen Komponente sowie ein auf diese Weise hergestelltes Bauelement sowie Sensor oder Aktor mit einem derartigen Bauelement hervor.

Der Erfindung liegt die Aufgabe zugrunde, Bauteile und Verfahren anzugeben, die eine Integration eines elektrischen Bauteils in einem metallischen Gussmaterial mittels eines beliebigen Gießprozesses erlauben.

Diese Aufgabe wird gelöst durch ein Konstruktionsbauteil gemäß Anspruch 1. So kann die Schutzschicht aus einem Schutzmaterial bestehen, dessen Schmelzpunkt bei der gleichen oder einer höheren Temperatur liegt als die für das elektrische Bauteil spezifizierte maximale Vergießtemperatur.

Die Erfindung hat den Vorteil, dass das elektrische Bauteil mittels eines beliebigen Gießverfahrens in einem metallischen Gussmaterial eingegossen werden kann. Es ist insbesondere keine Beschränkung auf Druckguss vorhanden. Es kann jedes Gießverfahren, welches für den Anwendungsfall adäquat erscheint, eingesetzt werden, wie das Gießen mit verlorener Form oder das Gießen in Dauerform. Das erfindungsgemäße elektrische Bauteil behält während und nach dem Gießprozess seine elektrische Funktionalität bei und kann anschließend ohne Einschränkungen genutzt werden.

Unter Thermoschock versteht man die schnelle, schockartige Veränderung der Temperatur am Material oder Werkstück. Dies führt zu mechanischen Spannungen zwischen dem äußeren und inneren Teil des Materials, da die Wärme zur oder von der Oberfläche schneller übertragen bzw. abgeführt wird als zum Inneren. Als eingießfähig gilt ein Bauteil, wenn es bei Aufrechterhaltung der Funktionsfähigkeit des Bauteils mittels eines Gießprozesses in dem Gussmaterial integrierbar ist.

Die Erfindung eignet sich für elektrische Bauteile jeder Art. Als elektrisches Bauteil wird dabei der kleinste grundlegende, als Einheit betrachtete Bestandteil einer elektrischen Schaltung sowohl als mathematisch-physikalisches Phänomen als auch in der Form eines idealisierten Bauelementes, als reales (diskretes) Bauelement oder als Baugruppe verstanden.

Auf diese Weise kann ein elektrisches Bauteil bereitgestellt werden, dass für eine maximale Vergießtemperatur ≥ 400° Celsius oder ≥ 500° Celsius spezifiziert sein kann. Das elektrische Bauteil kann ein passives elektrisches Bauteil sein, z.B. eine elektrische Leitung (einadrig oder mehradrig), eine elektrische oder elektronische Schaltung, ein Sensor und/oder ein Aktor. Das elektrische Bauteil kann z.B. als AMR-Sensor (AMR - anisotroper magnetoresistiver Effekt), als Hall-Sensor oder als Dehnungssensor, z.B. auf Platinbasis, ausgebildet sein. Das elektrische Bauteil kann, wenn es als Aktor ausgebildet ist, z.B. eine Spule aufweisen. Allgemein kann das elektrische Bauteil mit oder ohne Substrat ausgebildet sein. Weist das elektrische Bauteil ein Substrat auf, so können auf dem Substrat weitere elektrische Komponenten angeordnet sein, wie z.B. eine oder mehrere Sensorschichten und/oder Aktorschichten, sowie weitere Materialschichten wie die eingangs erwähnte elektrisch isolierende Materialschicht und die Schutzschicht. Das elektrische Bauteil kann z.B. ein Substrat aufweisen, auf das eine elektrisch leitende Schicht aufgebracht ist, die z.B. als Sensorschicht dienen kann, wenn das elektrische Bauteil als Sensor ausgebildet ist.

Gemäß einer vorteilhaften Weiterbildung der Erfindung weist das elektrische Bauteil wenigstens einen elektrischen Sensor, einen elektrischen Aktor und/oder ein sonstiges passives oder aktives elektrisches Bauteil auf oder besteht daraus.

Das elektrische Bauteil kann ganz oder teilweise mit der elektrisch isolierenden Materialschicht beschichtet sein. Die Schutzschicht kann das elektrische Bauteil vollständig umhüllen oder nur Teile davon bedecken, z.B. die elektrisch isolierende Materialschicht ganz oder teilweise bedecken oder weitere Oberflächenbereiche des elektrischen Bauteils.

Durch die Schutzschicht wird das elektrische Bauteil vor Beschädigungen durch die beim Gießprozess auftretende Wärme geschützt. Die Schutzschicht fungiert dabei wie ein Schutzschild, der an der äußeren, zum Gussmaterial hingerichteten Seite von diesem zumindest oberflächlich angeschmolzen werden kann, die aber ein Durchschmelzen bis zum elektrischen Bauteil verhindert. Dieser Effekt ist durchaus vorteilhaft, da auf diese Weise eine stoffschlüssige Verbindung zwischen dem elektrischen Bauteil und dem Gussmaterial hergestellt werden kann. Auf diese Weise kann ein stoffschlüssig an das metallische Gussmaterial anbindbares elektrisches Bauteil bereitgestellt werden.

Gemäß einer vorteilhaften Weiterbildung der Erfindung ist das elektrische Bauteil für ein bestimmtes metallisches Gussmaterial spezifiziert, in dem es mittels des Gießprozesses eingießfähig ist. Das elektrische Bauteil weist ein Substrat auf, das aus dem gleichen Material besteht wie das spezifizierte Gussmaterial. Dies erlaubt eine vorteilhafte Integration des elektrischen Bauteils in dem spezifizierten Gussmaterial. Insbesondere können auf diese Weise gleiche mechanische und thermische Eigenschaften (Ausdehnungskoeffizient) realisiert werden, so dass sich das elektrische Bauteil in jeder Hinsicht gut in das Gussmaterial einfügt. Es werden hierdurch zudem nachteilige Effekte auf die mechanische Stabilität eines Konstruktionsbauteils vermieden, das aus dem metallischen Gussmaterial hergestellt ist.

Gemäß einer vorteilhaften Weiterbildung der Erfindung ist die Schutzschicht mit einer Antioxidationsschicht aus einem Antioxidationsmaterial beschichtet, durch die die Schutzschicht vor Oxidation geschützt ist. Dies hat den Vorteil, dass bei oxidationsanfälligen Schutzmaterialien die unerwünschte Oxidation vermieden werden kann, mit dem Effekt, dass das Gussmaterial und das damit hergestellte Bauteil nicht durch Oxidreste verunreinigt werden.

Gemäß einer vorteilhaften Weiterbildung der Erfindung liegt der Schmelzpunkt der Antioxidationsschicht bei einer niedrigeren Temperatur als die für das elektrische Bauteil spezifizierte maximale Vergießtemperatur. Dies hat den Vorteil, dass die Antioxidationsschicht im Verlaufe des Gießprozesses durch die Erwärmung durch das Gussmaterial entfernt oder zumindest aufgebrochen werden kann. Die verbleibenden Reste der Antioxidationsschicht sind für die Qualität und Funktion des auf diese Weise hergestellten Gussbauteils unerheblich.

Gemäß einer vorteilhaften Weiterbildung der Erfindung ist das elektrische Bauteil für eines oder mehrere metallische Gussmaterialien spezifiziert, in denen es mittels des Gießprozesses eingießfähig ist, wobei das Schutzmaterial wenigstens eine der folgenden Bedingungen erfüllt:
a) es ist das gleiche Material wie zumindest eines der für das elektrische Bauteil spezifizierten Gussmaterialien,
b) es ist ein Material, das mit zumindest einem der für das elektrische Bauteil spezifizierten Gussmaterialien eine intermetallische Phase bildet,
c) es ist ein Material, das mit zumindest einem der für das elektrische Bauteil spezifizierten Gussmaterialien eine Legierung bildet, insbesondere eine eutektische Legierung.

Dies hat den Vorteil, dass das elektrische Bauteil über die Schutzschicht eine stoffschlüssige Verbindung zu dem Gussmaterial eingehen kann, die dauerhaft haltbar ist.

Die zuvor erläuterten Merkmale des elektrischen Bauteils können insbesondere schon vorliegen, bevor das elektrische Bauteil in dem metallischen Gussmaterial eingegossen worden ist, d.h. die entsprechenden Eigenschaften werden nicht erst im Laufe des Eingießprozesses erzeugt.

Das Konstruktionsbauteil kann z.B. ein Kraftfahrzeugbauteil sein oder ein Bauteil eines anderen technischen Gegenstands. Auch hierdurch können die zuvor erläuterten Vorteile realisiert werden.

Die eingangs genannte Aufgabe wird außerdem gelöst durch ein Verfahren gemäß Anspruch 6.

Auch hierdurch lassen sich die eingangs erläuterten Vorteile realisieren.

Gemäß einer vorteilhaften Weiterbildung der Erfindung wird das elektrische Bauteil auf seiner Schutzschicht mit einer Antioxidationsschicht mit einem Antioxidationsmaterial beschichtet. Dies hat den Vorteil, dass bei oxidationsanfälligen Schutzmaterialien die unerwünschte Oxidation vermieden werden kann. Gemäß einer vorteilhaften Weiterbildung der Erfindung wird das elektrische Bauteil in einem für das elektrische Bauteil spezifizierten metallischen Gussmaterial eingegossen, wobei eine stoffschlüssige Verbindung zwischen dem Schutzmaterial der Schutzschicht des elektrischen Bauteils und dem Gussmaterial gebildet wird.

Gemäß einer vorteilhaften Weiterbildung der Erfindung wird im Verlaufe des Heißgießprozesses eine auf der Schutzschicht vorhandene Antioxidationsschicht entfernt oder zumindest aufgebrochen. Dies hat den Vorteil, dass die stoffschlüssige Verbindung zwischen dem Schutzmaterial und dem Gussmaterial nicht oder nur unwesentlich durch das Antioxidationsmaterial gestört wird.

Das Beschichten des elektrischen Bauteils bzw. eines Substrats mit der elektrisch leitenden Schicht, der elektrisch isolierenden Materialschicht, der Schutzschicht und/oder der Antioxidationsschicht kann nach einem oder verschiedenen bekannten Verfahren erfolgen, z.B. nasschemisch, durch Aufspritzen, z.B. thermisches Kaltgasspritzen, oder in einem Vakuumverfahren wie z.B. Sputtern oder einem PVD- oder CVD-Prozess sowie Tauchbeschichtungen oder Walzplattierprozesse.

Die genannten Beschichtungsschritte für die einzelnen Schichten können z.B. in derselben Beschichtungsanlage durchgeführt werden. Soll eine bestimmte Schicht strukturiert werden, z.B. die elektrisch leitende Schicht, um eine Sensorschicht zu bilden, kann dies in einer separaten Anlage durchgeführt werden.

Bei der vorliegenden Erfindung ist es insbesondere möglich, dass das elektrische Bauteil ohne zusätzliche Hilfsmittel, wie z.B. Positionierhilfsmittel zum Positionieren des elektrischen Bauteils beim Eingießvorgang, in dem metallischen Gussmaterial eingegossen wird. Es ist nicht erforderlich, dass das elektrische Bauteil mit einem solchen Positionierhilfsmittel verbunden wird oder dadurch gehalten wird. Vielmehr kann das elektrische Bauteil selbst von außen, d.h. von einem Bereich, der nicht mit dem metallischen Gussmaterial vergossen wird, gehalten werden. Ein bestimmter Teilbereich des elektrischen Bauteils steht dann nach dem Gießprozess aus dem metallischen Gussmaterial heraus. An diesem herausstehenden Teilbereich können z.B. elektrische Kontakte des elektrischen Bauteils angeordnet sein. Dies hat den Vorteil, dass der gesamte Herstellprozess vereinfacht wird, da insbesondere das elektrische Bauteil vor dem Eingießprozess nicht noch vorbehandelt werden muss, d.h. nicht mit einem Positionierelement verbunden werden muss.

Die Erfindung wird nachfolgend anhand von Ausführungsbeispielen unter Verwendung von Zeichnungen näher erläutert.

Es zeigen
- Figur 1: ein elektrisches Bauteil in Form eines Sensors und
- Figur 2: ein Konstruktionsbauteil mit einem darin eingegossenen elektrischem Bauteil und
- Figur 3: das elektrische Bauteil gemäß Figur 1 im Querschnitt und
- Figuren 4 und 5: weitere elektrische Bauteile im Querschnitt.

In den Figuren werden gleiche Bezugszeichen für einander entsprechende Elemente verwendet.

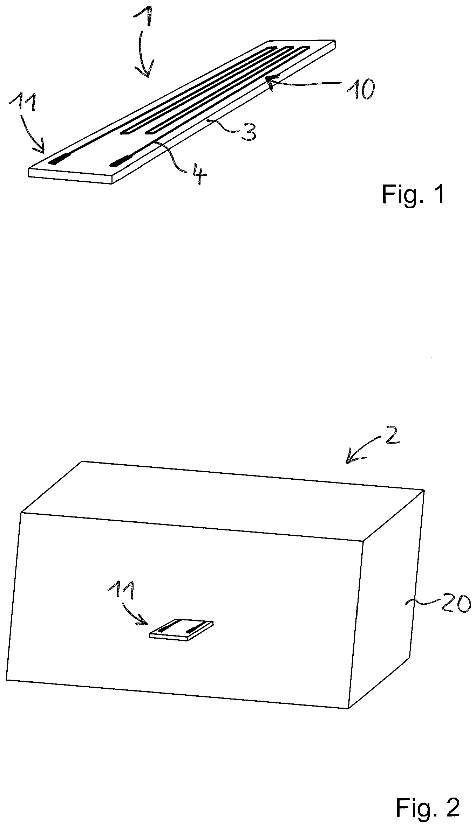

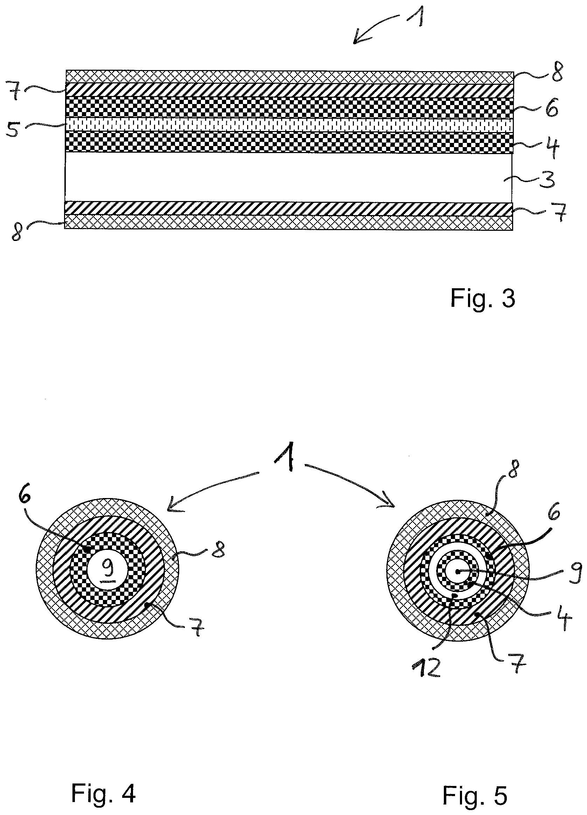

Die Figur 1 zeigt in perspektivischer Ansicht ein elektrisches Bauteil 1 in Form eines AMR-Sensors. Das elektrische Bauteil 1 weist einen Sensorbereich 10 und einen elektrischen Kontaktierungsbereich 11 auf. Im elektrischen Kontaktierungsbereich 11 sind Anschlussflächen zum Anschluss, z.B. zum Anlöten, elektrischer Leitungen vorhanden, um den Sensor mit einer Auswerteschaltung zu verbinden. Das elektrische Bauteil 1 ist mehrschichtig aufgebaut. Auf einem Substrat 3 sind verschiedene Schichten aufgebracht, die nachfolgend noch anhand der Figur 3 erläutert werden. Erkennbar ist in der Figur 1 insbesondere eine strukturierte elektrisch leitende Schicht 4, die, um einen AMR-Sensor zu bilden, im Sensorbereich 10 mäanderförmig strukturiert ist und die im Kontaktierungsbereich 11 die elektrischen Anschlussflächen aufweist.

Das elektrische Bauteil 1 gemäß Figur 1 ist in einem metallischen Gussmaterial eingießfähig. Die Figur 2 zeigt dies anhand eines Konstruktionsbauteils, das hier beispielhaft ausschnittsweise dargestellt ist und das als Gussbauteil 2 aus einem metallischen Gussmaterial 20 gegossen ist, wobei ein elektrisches Bauteil 1 in das Gussmaterial 20 eingegossen ist. Insbesondere ist der Sensorbereich 10 in dem Gussmaterial 20 eingegossen. Der Kontaktierungsbereich 11 steht daraus hervor, so dass er zum Anschluss elektrischer Leitungen zugänglich ist.

Die Figur 3 zeigt im Detail den Schichtaufbau des elektrischen Bauteils 1 anhand eines Querschnitts durch das Bauteil. Das Substrat 3 ist an seiner oben dargestellten Oberflächenseite mit einer elektrisch isolierenden Materialschicht 4 beschichtet. Darauf ist eine elektrisch leitende Materialschicht 5 angeordnet. Die elektrisch leitende Materialschicht 5 ist mit einer weiteren elektrisch isolierenden Materialschicht 6 beschichtet. Auf der elektrisch isolierenden Materialschicht 6 ist eine Schutzschicht 7 aus einem Schutzmaterial angeordnet. Auf der Schutzschicht ist eine Antioxidationsschicht 8 aus einem Antioxidationsmaterial aufgebracht. Zur Unterseite hin ist das Substrat 3 zunächst ggf. mit der Schutzschicht 7 beschichtet. Auf dieser ist die Antioxidationsschicht 8 angeordnet. Das elektrische Bauteil 1 kann durch die Wärmeisolationsschicht 7 und die Antioxidationsschicht 8 vollständig umhüllt sein, so dass es durch diese Schichten gekapselt ist. Zur elektrischen Kontaktierung des elektrischen Bauteils 1 im Kontaktierungsbereich 11 kann dieser zumindest an den Anschlussflächen von den Schichten 6, 7, 8 freigelegt sein.

Die Figur 4 zeigt eine weitere Ausführungsform eines elektrischen Bauteils 1 in Form einer elektrischen Leitung, die z.B. als starrer Leiter oder als Litze ausgebildet sein kann. Erkennbar ist der konzentrische Aufbau aus mehreren Schichten. Im Inneren befindet sich eine elektrisch leitfähige Schicht, die einen elektrischen Leiter 9 bildet, z.B. in Form eines Kupferdrahts oder einer Kupferlitze. Der elektrische Leiter 9 ist durch eine elektrisch isolierende Materialschicht 6, wie zuvor erläutert, umhüllt. Die elektrisch isolierende Materialschicht 6 ist von einer Schutzschicht 7 umhüllt. Die Schutzschicht 7 ist von einer Antioxidationsschicht 8 umhüllt. Auf diese Weise kann eine einadrige oder auch mehradrige elektrische Leitung als ein eingießfähiges elektrisches Bauteil bereitgestellt werden, das in einem metallischen Gussmaterial eingegossen werden kann. So kann z.B. das elektrische Bauteil 1 gemäß Figur 4 in einem aus Gussmaterial hergestellten Motorblock eines Verbrennungsmotors eines Kraftfahrzeugs eingegossen werden, so dass eine elektrische Verbindung vom Inneren des Motorblocks zur Außenumgebung hin durch das Gussmaterial des Motorblocks hindurch geschaffen werden kann. Es kann auf diese Weise auch ein Sensor in einen Achsschenkel eingegossen werden.

Die Figur 5 zeigt eine ähnliche Ausführungsform eines elektrischen Bauteils 1 wie die Figur 1, nämlich in Form einer elektrischen Leitung, im Fall der Figur 5 allerdings in Form einer Koaxialleitung mit einem Innenleiter 9 und einem Außenleiter 12. Der Innenleiter 9 und/oder der Außenleiter 12 können z.B. aus Kupfer oder einem anderen geeigneten elektrisch leitfähigen Material gebildet sein. Der Innenleiter 9 ist von einer elektrisch isolierenden Materialschicht 4 umhüllt. Die elektrisch isolierende Materialschicht 4 ist von dem Außenleiter 12 umhüllt. Der Außenleiter 12 ist von einer weiteren elektrisch isolierenden Materialschicht 6 umhüllt. Diese ist wiederum durch die Schutzschicht 7 umhüllt. Die Schutzschicht 7 ist von der Antioxidationsschicht 8 umhüllt.

Die Schichten 4, 5, 6, 7, 8 können relativ dünn ausgebildet sein, z.B. im Bereich von 50 nm bis 10 µm. Die elektrisch leitende Schicht 5 kann insbesondere eine Schichtdicke im Bereich von 100 nm bis 300 nm aufweisen. Die Isolationsschichten 4, 6 können insbesondere eine Dicke im Bereich von 0,5 µm bis 6 µm aufweisen.

Als Material für das Substrat 3 kann insbesondere das gleiche Material verwendet werden wie das Gussmaterial 20. Geeignete Materialien für das Substrat sind z.B. Aluminium oder Stahl.

Die elektrische Isolationsschicht 4, 6 kann z.B. als Sandwich-Schicht ausgebildet sein, indem zwischen zwei Außenschichten eine Innenschicht gebildet ist. Ein geeignetes Material für die Außenschichten ist z.B. Aluminiumoxid (Al₂O₃) oder Hafniumcarbid (HfC). Ein geeignetes Material für die Innenschicht ist z.B. Siliziumdioxid (SiO₂) oder Siliziumcarbid (SiC). Vorteilhaft ist insbesondere die Verwendung eines Materials für die Isolationsschicht 4, das werkstofftechnisch eine Affinität bzw. Haftfestigkeit zum Substratwerkstoff aufweist.

Die elektrisch leitfähige Schicht 5 kann als Verbundschicht aus zwei Materialien ausgebildet sein, z.B. einer Chromschicht mit etwa 50 nm Dicke und einer Nickel-Eisen (NiFe) Schicht mit etwa 200 nm Dicke.

Als Schutzmaterial für die Schutzschicht 6 kann insbesondere Aluminium oder ein eisenhaltiger Werkstoff verwendet werden. Ein geeignetes Antioxidationsmaterial zur Bildung der Antioxidationsschicht 8 ist z.B. Gold oder Platin. Die Antioxidationsschicht 8 kann auch aus Zink oder einer Zinklegierung bestehen.

Es kann als weitere Außenschicht eine Haftvermittlungsschicht vorgesehen werden, die die Haftung zur elektrisch leitfähigen Schicht 5 realisiert.

Für Stahlbauteile hat sich z.B. als zielführend erwiesen, einen Baustahl zu verwenden, der mit einer Hafniumcarbid-Schicht beschichtet wird, z.B. durch Sputtern. Die Hafniumcarbid-Schicht wird durch eine Haftvermittlungsschicht mit einer weiteren Hafniumcarbid-Schicht verbunden. Anschließend wird eine sensitive Nickel-Eisen-Schicht mit einem Haftvermittler auf Chrombasis auf die Hafniumcarbid-Schicht aufgetragen. Auf der sensitiven Sensorschicht wird wiederum ein Sandwich aus einer Hafniumcarbid-Schicht, einer Haftvermittlungsschicht und einer weiteren Hafniumcarbid-Schicht aufgetragen, so dass die sensitive Sensorschicht von zwei auf diese Weise gebildeten Isolationsschichten umgeben ist. Als Beschichtungswerkstoffe können vorteilhaft auch Nitride verwendet werden, wie sie auch bei beschichteten Wendeschneidplatten zum

Einsatz kommen. Vorteilhaft sind insbesondere Bor-Nitride und Titan-Nitride.

Die zuvor erläuterten Beschichtungen können innerhalb einer PVD-Vakuumanlage durchgeführt werden. Anschließend kann durch einen thermischen Spritzprozess, z.B. ein Lichtbogen-Spritzverfahren, eine dünne Stahlschicht auf die äußere Isolationsschicht 6 aufgetragen werden, um die Schutzschicht 7 zu bilden. Innerhalb eines sich anschließenden weiteren Beschichtungsprozesses, z.B. eines Sputterätzprozesses, kann die entstandene Oxidschicht entfernt und eine z.B. 0,08 µm dicke Goldschicht als Antioxidationsschicht 8 aufgebracht werden. Es ist dann ein elektrisches Bauteil 1 bereitgestellt, das in einer Gussform platziert werden kann und mittels eines Gießprozesses in das herzustellende Gussteil 2 integriert werden kann.

Vorteilhaft ist es insbesondere, als Isolationswerkstoffe Materialien zu nehmen, die einen deutlich höheren Schmelzpunkt haben als der für das Bauteil spezifizierte Gusswerkstoff 20. Zudem müssen sie eine werkstofftechnische Affinität zum verwendeten Substrat 3 besitzen. Die Schichten werden dabei vorteilhafterweise so dünn ausgeführt, dass ihre thermische Leitfähigkeit die Folgen einer Thermoschockreaktion verhindert.

Als weiteres Beispiel kann angegeben werden, dass auf Grundlage einer Aluminiumbasislegierung ein elektrisches Bauteil 1 hergestellt werden kann. Hierbei wird auf einem Aluminium-Substrat 3 eine isolierende Aluminiumdioxidkeramik aufgebracht, z.B. durch Sputtern, die wiederum durch einen auf SiO₂-Basis begründeten Pinholefüller mit wenigstens einer weiteren Aluminiumdioxid-Schicht verbunden wird. Hierauf wird eine weitere Haftvermittlungsschicht auf Chrombasis aufgebracht, z.B. durch Sputtern, der als Sensorschicht eine elektrisch leitfähige Schicht 5 auf Nickel-Eisenbasis folgt. Zu Isolationszwecken wird hierauf wiederum eine Aluminiumoxidschicht durch einen Haftvermittler auf die Nickel-Eisenschicht aufgebracht. Anschließend wird eine Aluminiumschicht innerhalb desselben Beschichtungsprozesses aufgebracht, um die Schutzschicht 7 zu bilden. Auf der Schutzschicht 7 wird eine Antioxidationsschicht 8 auf Goldbasis aufgebracht. Das so erhaltene elektrische Bauteil 1 kann insbesondere in Aluminiumwerkstoff als Gussmaterial eingegossen werden, ohne dass das elektrische Bauteil 1 und insbesondere die elektrisch leitende Schicht 5 durch den Gießprozess beschädigt wird.

## Patentansprüche

1. Konstruktionsbauteil eines technischen Gegenstands, das als ein aus einem metallischen Gussmaterial (20) hergestelltes Gussbauteil (2) ausgebildet ist, wobei in das Gussbauteil (2) ein elektrisches Bauteil (1) eingegossen ist, das in einem metallischen Gussmaterial (20) mittels eines Gießprozesses eingießfähig ist und für eine maximale Vergießtemperatur des Gießprozesses spezifiziert ist, wobei wenigstens elektrisch leitende Oberflächenbereiche des elektrischen Bauteils (1) mit einer elektrisch isolierenden Materialschicht (4, 6) beschichtet sind und auf der elektrisch isolierenden Materialschicht (4, 6) eine Schutzschicht (7) zum Schmelzestopp, zur Schmelzeanbindung und/oder zur Thermoschockkompensation angeordnet ist, deren Schmelzpunkt bei der gleichen oder einer höheren Temperatur liegt als die für das elektrische Bauteil (1) spezifizierte maximale Vergießtemperatur, **dadurch gekennzeichnet, dass** ein Bereich des elektrischen Bauteils (1), an dem das elektrische Bauteil (1) beim Eingießvorgang gehalten ist und der nicht mit dem Gussmaterial vergossen ist, nach dem Gießprozess aus dem metallischen Gussmaterial (20) heraussteht.

2. Konstruktionsbauteil nach dem vorhergehenden Anspruch, **dadurch gekennzeichnet, dass** die Schutzschicht (7) mit einer Antioxidationsschicht (8) aus einem Antioxidationsmaterial beschichtet ist, durch die die Schutzschicht (7) vor Oxidation geschützt ist.

3. Konstruktionsbauteil nach dem vorhergehenden Anspruch, **dadurch gekennzeichnet, dass** der Schmelzpunkt der Antioxidationsschicht (8) bei einer niedrigeren Temperatur liegt als die für das elektrische Bauteil (1) spezifizierte maximale Vergießtemperatur.

4. Konstruktionsbauteil nach einem der vorhergehenden Ansprüche, **dadurch gekennzeichnet, dass** das elektrische Bauteil (1), wenigstens einen elektrischen Sensor, einen elektrischen Aktor und/oder ein sonstiges passives oder aktives elektrisches Bauteil aufweist oder daraus besteht.

5. Konstruktionsbauteil nach einem der vorhergehenden Ansprüche, **dadurch gekennzeichnet, dass** das elektrische Bauteil (1) für eines oder mehrere bestimmte metallische Gussmaterialien (20) spezifiziert ist, in denen es mittels des Gießprozesses eingießfähig ist, wobei die Schutzschicht (7) aus einem Schutzmaterial besteht, das wenigstens eine der folgenden Bedingungen erfüllt:
a) es ist das gleiche Material wie zumindest eines der für das elektrische Bauteil (1) spezifizierten Gussmaterialien (20),
b) es ist ein Material, das mit zumindest einem der für das elektrische Bauteil (1) spezifizierten Gussmaterialien (20) eine intermetallische Phase bildet,
c) es ist ein Material, das mit zumindest einem der für das elektrische Bauteil (1) spezifizierten Gussmaterialien (20) eine Legierung bildet.

6. Verfahren zur Herstellung eines Konstruktionsbauteils (1) nach einem der Ansprüche 1 bis 5, **gekennzeichnet durch** folgende Schritte:
a) Bereitstellen eines elektrischen Bauteils (1),
b) Spezifizieren einer maximalen Vergießtemperatur des elektrischen Bauteils (1),
c) Beschichten des elektrischen Bauteils (1) zumindest an elektrisch leitenden Oberflächenbereichen mit einer elektrisch isolierenden Materialschicht (4, 6),
d) Auswählen eines Schutzmaterials und Beschichten des elektrischen Bauteils oder zumindest der elektrisch isolierenden Materialschicht (4, 6) mit dem ausgewählten Schutzmaterial, um eine Schutzschicht (7) zu bilden,
e) Eingießen des elektrischen Bauteils (1) mittels eines Gießprozesses in einem metallischen Gussmaterial (20), wobei das elektrische Bauteil (1) beim Eingießvorgang an einem Bereich des elektrischen Bauteils (1), der nicht mit dem metallischen Gussmaterial (20) vergossen wird, gehalten wird, sodass dieser Bereich des elektrischen Bauteils (1) nach dem Gießprozess aus dem metallischen Gussmaterial (20) heraussteht.

7. Verfahren nach dem vorhergehenden Anspruch, **dadurch gekennzeichnet, dass** das elektrische Bauteil (1) auf seiner Schutzschicht (7) mit einer Antioxidationsschicht (8) aus einem Antioxidationsmaterial beschichtet wird.

8. Verfahren nach Anspruch 6 oder 7, **dadurch gekennzeichnet, dass** das elektrische Bauteil (1) in einem für das elektrische Bauteil (1) spezifizierten metallischen Gussmaterial (20) eingegossen wird, wobei eine stoffschlüssige Verbindung zwischen dem Schutzmaterial der Schutzschicht (7) des elektrischen Bauteils (1) und dem Gussmaterial (20) gebildet wird.

9. Verfahren nach einem der Ansprüche 6 bis 8, **dadurch gekennzeichnet, dass** im Verlaufe des Gießprozesses eine auf der Schutzschicht (7) vorhandene Antioxidationsschicht (8) entfernt oder zumindest aufgebrochen wird.

## Claims

1. Structural component of a technical object, which is formed as a cast component (2) produced from a metallic casting material (20), wherein an electrical component (1) that is capable of being cast in a metallic casting material (20) by means of a casting process and has been specified for a maximum casting temperature of the casting process has been cast in the cast component (2), wherein at least electrically conducting surface regions of the electrical component (1) are coated with an electrically insulating material layer (4, 6) and arranged on the electrically insulating material layer (4, 6) is a protective layer (7) for resisting the melt, superficially bonding with the melt and/or compensating for thermal shock, the melting point of which is at the same temperature or a higher temperature than the maximum casting temperature specified for the electrical component (1), **characterized in that** a region of the electrical component (1) at which the electrical component (1) is held during the casting-in operation and which is not cast with the casting material protrudes out of the metallic casting material (20) after the casting process.

2. Structural component according to the preceding claim, **characterized in that** the protective layer (7) is coated with an antioxidation layer (8) of an antioxidation material, by which the protective layer (7) is protected from oxidation.

3. Structural component according to the preceding claim, **characterized in that** the melting point of the antioxidation layer (8) is at a lower temperature than the maximum casting temperature specified for the electrical component (1).

4. Structural component according to one of the preceding claims, **characterized in that** the electrical component (1) comprises or consists of at least an electrical sensor, an electrical actuator and/or some other passive or active electrical component.

5. Structural component according to one of the preceding claims, **characterized in that** the electrical component (1) has been specified for one or more specific metallic casting materials (20) in which it is capable of being cast by means of the casting process, wherein the protective layer (7) consists of a protective material that satisfies at least one of the following conditions:
a) it is the same material as at least one of the casting materials (20) specified for the electrical component (1),
b) it is a material that forms an intermetallic phase with at least one of the casting materials (20) specified for the electrical component (1),
c) it is a material that forms an alloy with at least one of the casting materials (20) specified for the electrical component (1).

6. Method for producing a structural component (1) according to one of Claims 1 to 5, **characterized by** the following steps:
a) providing an electrical component (1),
b) specifying a maximum casting temperature of the electrical component (1),
c) coating the electrical component (1) at least on electrically conducting surface regions with an electrically insulating material layer (4, 6),
d) selecting a protective material and coating the electrical component or at least the electrically insulating material layer (4, 6) with the selected protective material in order to form a protective layer (7),
e) casting the electrical component (1) in a metallic casting material (20) by means of a casting process, wherein the electrical component (1) is held during the casting-in operation at a region of the electrical component (1) that is not cast with the metallic casting material (20), so that this region of the electrical component (1) protrudes out of the metallic casting material (20) after the casting process.

7. Method according to the preceding claim, **characterized in that** the electrical component (1) is coated on its protective layer (7) with an antioxidation layer (8) of an antioxidation material.

8. Method according to Claim 6 or 7, **characterized in that** the electrical component (1) is cast in a metallic casting material (20) specified for the electrical component (1), wherein a material-bonding connection is formed between the protective material of the protective layer (7) of the electrical component (1) and the casting material (20).

9. Method according to one of Claims 6 to 8, **characterized in that** in the course of the casting process an antioxidation layer (8) that is present on the protective layer (7) is removed or is at least broken open.

## Revendications

1. Composant de construction d'un objet technique, lequel composant de construction est conçu comme un composant coulé (2) fabriqué à partir d'un matériau de coulée métallique (20), un composant électrique (1) étant coulé dans le composant coulé (2), lequel composant électrique peut être coulé dans un matériau de coulée métallique (20) par un processus de coulée et spécifié pour une température de coulée maximale du processus de coulée, au moins des régions superficielles électriquement conductrices du composant électrique (1) étant revêtues d'une couche de matériau électriquement isolant (4, 6) et une couche protectrice (7) servant à arrêter la matière fondue, à lier la matière fondue et/ou à compenser les chocs thermiques étant disposée sur la couche de matériau électriquement isolant (4, 6), laquelle couche protectrice a un point de fusion supérieur ou égal à la température de coulée maximale spécifiée pour le composant électrique (1), **caractérisé en ce qu'**une région du composant électrique (1), sur laquelle le composant électrique (1) est maintenu pendant l'opération de coulée et qui n'est pas coulée avec le matériau de coulée, dépasse du matériau de coulée métallique (20) après le processus de coulée.

2. Composant de construction selon la revendication précédente, **caractérisé en ce que** la couche protectrice (7) est recouverte d'une couche d'antioxydant (8) en matériau antioxydant au moyen de laquelle la couche protectrice (7) est protégée de l'oxydation.

3. Composant de construction selon la revendication précédente, **caractérisé en ce que** le point de fusion de la couche d'antioxydant (8) est à une température inférieure à la température de coulée maximale spécifiée pour le composant électrique (1).

4. Composant de construction selon l'une des revendications précédentes, **caractérisé en ce que** le composant électrique (1) comprend au moins un capteur électrique, un actionneur électrique et/ou un autre composant électrique passif ou actif ou est constitué de ceux-ci.

5. Composant de construction selon l'une des revendications précédentes, **caractérisé en ce que** le composant électrique (1) est spécifié pour un ou plusieurs matériaux de coulée métalliques déterminés (20) dans lesquels il est coulable par le processus de coulée, la couche protectrice (7) étant en matériau protecteur qui remplit au moins l'une des conditions suivantes :
a) il s'agit du même matériau qu'au moins un des matériaux de coulée (20) spécifiés pour le composant électrique (1),
b) il s'agit d'un matériau qui forme une phase intermétallique avec au moins un des matériaux de coulée (20) spécifiés pour le composant électrique (1),
c) il s'agit d'un matériau qui forme un alliage avec l'un au moins des matériaux de coulée (20) spécifiés pour le composant électrique (1).

6. Procédé de fabrication d'un composant de construction (1) selon l'une des revendications 1 à 5, **caractérisé par** les étapes suivantes :
a) fournir un composant électrique (1),
b) spécifier une température de coulée maximale du composant électrique (1),
c) revêtir le composant électrique (1), sur au moins des zones superficielles électriquement conductrices, d'une couche de matériau électriquement isolant (4, 6),
d) sélectionner un matériau protecteur et revêtir le composant électrique, ou au moins la couche de matériau électriquement isolant (4, 6), du matériau protecteur sélectionné pour former une couche protectrice (7),
e) couler le composant électrique (1) dans un matériau de coulée métallique (20) par un processus de coulée, le composant électrique (1) étant maintenu au niveau de la région du composant électrique (1), qui n'est pas coulée avec le matériau de coulée métallique (20), pendant l'opération de coulée de sorte que cette région du composant électrique (1) dépasse du matériau de coulée métallique après le processus de coulée (20).

7. Procédé selon la revendication précédente, **caractérisé en ce que** le composant électrique (1) est revêtu, sur sa couche protectrice (7), d'une couche d'antioxydant (8) en matériau antioxydant.

8. Procédé selon la revendication 6 ou 7, **caractérisé en ce que** le composant électrique (1) est coulé dans un matériau de coulée métallique (20) spécifié pour le composant électrique (1), une liaison de matière étant formée entre le matériau protecteur de la couche protectrice (7) du composant électrique (1) et le matériau de coulée (20).

9. Procédé selon l'une des revendications 6 à 8, **caractérisé en ce que**, lors du processus de coulée, une couche d'antioxydant (8) présente sur la couche protectrice (7) est retirée ou au moins brisée.
